# EUROPEAN PATENT SPECIFICATION

(11) **EP 1 497 924 B1**
(45) Date of publication and mention of the grant of the patent: **12.07.2006**
(21) Application number: 03710582.2
(22) Date of filing: 27.03.2003
(51) Int. Cl.: H03L 7/12, H03L 7/14

(54) **ARRANGEMENT AND METHOD RELATING TO PHASE LOCKING COMPRISING STORING MEANS**
ANORDNUNG UND VERFAHREN IN BEZUG AUF PHASENVERRIEGELUNG MIT SPEICHERMITTELN
AGENCEMENT ET PROCEDE RELATIFS AU VERROUILLAGE DE PHASE ET METTANT EN OEUVRE UN MOYEN DE STOCKAGE

(30) Priority: 02.04.2002 SE 0200975
(43) Date of publication of application: 19.01.2005
(73) Proprietor: TELEFONAKTIEBOLAGET LM ERICSSON (publ), 164 83 Stockholm (SE)
(72) Inventor: HYDEN, Lennart, S-412 75 Göteborg (SE); LOFTER, Björn, SE-444 60 Stora Höga (SE); CEDERLÖF, Mäns, S-411 39 Göteborg (SE)
(74) Representative: Bergentall, Annika Maria
(86) International application number: PCT/SE2003/000502
(87) International publication number: WO 2003/084068

(56) References cited:
- US-A- 4 077 016
- US-A- 5 552 727
- US-A- 6 157 804
- PATENT ABSTRACTS OF JAPAN & JP 06 097 821 A (NEC CORP) 08 April 1994

## Description

### FIELD OF THE INVENTION

The present invention relates to an arrangement for phase locking of a Voltage Controlled Oscillator (VCO) to a selected frequency harmonic of a number of predetermined, i.e. available, frequency harmonics of a reference frequency, comprising a reference generator for generating said reference frequency, a phase lock loop for producing an output signal in response to the input reference frequency, which phase lock loop comprises a phase detector, said VCO, a filter and a sweep generator, which arrangement further comprises or is associated with storing means for storing information, for each available frequency harmonic, a first control voltage providing a VCO output which differs from the selected harmonic by a given value, the sweep generator adding a controllable sweep voltage to the first control voltage at least until a varying, second difference between the output VCO frequency and the selected frequency harmonic reaches a given value. The invention also relates to a method for locking the phase of a Voltage Controlled Oscillator to a selected frequency harmonic of a number of available or predetermined frequency harmonics of an input reference frequency. The invention also relates to an arrangement and a method through which a frequency shift can be provided for.

### STATE OF THE ART

Pre-manufactured digital PLL (Phase Lock Loop) circuits are available which comprise a frequency as well as a phase lock functionality. Such circuits are advantageous in so far as they are simple to use. However, a disadvantage of such digital circuits is that the noise level is high, particularly a considerable noise of the phase of the phase locked VCO signal will result.

In addition thereto analogue phase detectors are known, particularly of the type "sample and hold" or mixers. The phase noise is much lower for such phase detectors, i.e. much lower than for digital arrangements. It is however a drawback of such circuits that they do not contain any frequency lock functionality. In order to provide for a frequency lock, the VCO has to be controlled or directed to the same frequency as the desired harmonic, multiple of the reference frequency. The deviation may not exceed the maximum of the bandwidth of the phase lock loop. Today known methods for driving the VCO to the appropriate frequency at phase locking are complicated and the time it takes to acquire phase lock is comparatively long.

From another known arrangement it is also known to lock the VCO using a PLL circuit. The control voltage input to the VCO is sampled, converted in an A/D converter and stored into a storing means. The PLL circuit is then disconnected, and instead an SPLL (Sampling PLL) circuit is connected. The stored value for the voltage is converted in a D/A converter and it is used to drive the VCO to the appropriate frequency. Even if the noise will be lower using such a method, it still takes a long time to perform a frequency shift.

US-A-5 703 538 discloses a radar exciter with a phase lock loop responsive to an input reference signal for producing an exciter output signal, with a rapid phase lock acquisition circuit having an output connected to the VCO during the phase acquisition mode for driving the VCO to a commanded frequency, and achieving phase lock. A ramp generator circuit is used for, in response to digital output control signals from a controller, generating ramp signals at the output connected to the VCO during the phase acquisition mode. Input signals (to controllers) include a zero beat signal for counting harmonics and indicating out-of-lock conditions, and the digital output control signals include digital ramp slope control signals, digital ramp start/stop signals and digital ramp direction signals. However, this device is complicated and requires complicated control means. For example it requires counting of harmonics and it is not fast enough, phase lock can be achieved in, advantageously, less than 40 microseconds, which is a comparatively long time for various implementations and usages.

GB-A-2336026 describes a method for calibration of an oscillating sweep oscillator. Calibration is done by producing a phase-locking to a multiple of a reference oscillator. A conventional PLL is used.

JP 06097821 A shows a frequency sweep rate adaptive phase locked loop allowing elimination of catching mistakes. It should further shorten the signal catching time by switching the frequency sweep rate of a VCO of a PLL to a lower level when the VCO is close to the input signal frequency.

It is however not possible to using, the teaching of these documents, achieve a phase lock fast enough, e.g. through simply using a PLL.

### SUMMARY OF THE INVENTION

What is needed is therefore an arrangement for phase locking which is faster than hitherto known arrangements, i.e. which acquire a phase lock condition faster than known arrangements. A phase locking arrangement is also needed which is easy to use, easy to manufacture and which has a simple structure.

Particularly a phase lock arrangement is needed through which the phase noise of a phase locked VCO signal will be low. An arrangement is also needed which allows for a fast frequency shift. Still further an arrangement is needed through which the risk of locking to the wrong frequency (harmonic), i.e. to another frequency than the selected one, is reduced. Still further an arrangement is needed which gives a secure phase lock to a selected frequency harmonic also with respect to the temperature dependence of the frequency, which depends on the voltage.

Therefore an arrangement as initially referred is provided which further comprises, or is associated with, monitoring/detecting means for detecting the difference between the selected frequency harmonic and the VCO output frequency. The sweep generator control means will control the sweep rate in dependence of the variable, also denoted second, frequency difference for reducing the sweep rate (as the second difference diminishes) until the VCO is phase locked to the selected frequency harmonic, i.e. when a phase lock condition has been achieved. It comprises an integrating loop filter for which the integrating functionality can be switched off. In other words the sweep rate is given by the "distance" to the selected frequency harmonic. In a particular implementation the monitoring/ detecting means provides for a continuous detection of the difference between the selected frequency harmonic and the VCO output frequency, i.e. of the variable, second, frequency difference (Δf_{c}). In an alternative implementation the monitoring/detecting means provides for a stepwise or discrete detection of the variable, second, frequency difference (Δf_{c}).

In a particularly advantageous implementation the sweep generator control means continuously reduces the sweep rate. In an alternative implementation the sweep generator control means stepwise reduces the sweep rate. It is also possible to provide a first, fixed sweep rate until the variable second frequency difference (Δf_{c}) assumes a given value and subsequently continuously or stepwise reduce the sweep rate until phase lock is achieved. It is also possible to reduce the sweep rate in a variable manner, e.g. to a lesser and lesser extent the smaller Δf_{c} gets.

Particularly an indication signal is provided at reaching said value for the variable second frequency difference (Δf_{c}).

In a particularly advantageous implementation the phase locking loop is a sampled phase lock loop (SPLL), i.e. the phase detector is a sampling phase detector. In another implementation the phase detector is not sampling. In principle the concept applies to any kind of phase detector.

Advantageously the sweep generator is disconnected or switched off when the VCO is phase locked. One reason to use an integrating filter is to be able to discharge the sweep voltage between different frequency shifts.

Advantageously a comparator is used to detect the/a signal from the phase detector. Particularly supplementary control means are provided to assure a continuous sweep from the sweep generator also when the comparator is not able to detect a signal from the phase detector. Such may with advantage be used particularly when the phase detector is narrow-banded, i.e. has a narrow bandwidth. Then it has to be possible to switch off the integrating functionality of the loop filter.

When a DC voltage is output or detected from the phase detector, phase lock has been achieved. Alternatively the time periods that lapse between subsequent pulses from the comparator are measured, and when and time intervals are long enough (Δf_{c} small enough), it is considered that phase lock has been achieved.

Here supplementary control means are not necessary if the phase detector has a sufficient bandwidth. However, the supplementary control means, when provided, or needed, provides control signals to the loop filter disposed between the phase detector (and optionally to adding means for providing the signal input to the VCO), optionally to the sweep generator, and to the storing means.

However, irrespectively of whether any supplementary control means are provided or not and how they are implemented, the signal from the phase detector is via a comparator and a mono-stable gate input to the sweep generator. In a preferred implementation a first signal pulse from the mono-stable gate is detected via a first signal indicating that a first fixed sweep rate is to be replaced by the second sweep, the rate of which is continuously or stepwise reduced as the detected second varying frequency difference (Δf_{c}) is reduced. Particularly this reduction occurs faster or continuously at a predetermined value of the second variable frequency difference, or slower and slower the smaller Δf_{c} gets.

According to the invention a D/A-converter is disposed between the storing means and the adding means providing the input signal to the VCO. (The voltage contributions from the loop filter and from the sweep generator to the adding means should at the beginning of the phase locking procedure or frequency shifting, be zero. Alternatively they may assume known, fixed values.)

A method for locking the phase of a voltage controlled oscillator to a selected frequency harmonic among a number of predetermined (available) frequency harmonics is therefore also suggested, which comprises the steps of; finding, in storing means, a first control voltage associated with the selected frequency harmonic which has a value such that the frequency of the VCO output will be lower than, (or higher than), and differ, by a given first value (Δf₁), from the selected frequency harmonic; applying the found, first control voltage; adding (superimposing) a sweep voltage (with a fixed rate) to the first control voltage; detecting/monitoring the (varying) frequency difference (Δf_{c}) between the VCO output frequency and the selected frequency harmonic; at least from a given detected frequency difference controlling the rate of the sweep voltage in dependence of the frequency difference by reducing it until the VCO is phase locked to the selected frequency harmonic. The method further includes the step of using an integrating switch-off able loop filter, which integrating loop filter, i.e. the integrating functionality thereof, is switched off when a phase lock procedure (frequency shift) is initiated, the integrating functionality being switched on when phase lock is achieved. The method in a most advantageous implementation comprises the step of monitoring the varying frequency difference (Δf_{c}) continuously. Alternatively the method comprises the step of detecting (establishing) the varying frequency difference (Δf_{c}) at discrete time intervals.

The method may further include, most advantageously, the step of further reducing the rate of the sweep continuously. More particularly the method comprises the steps of; providing a reference signal (having the selected frequency) to a phase detector, finding the first control voltage relevant to the selected harmonic of the reference frequency in storing means; converting in a D/A-converter the output from the storing means; applying the first control voltage to the VCO; detecting the second, varying, frequency difference in a sampling phase detector; using said second frequency difference to provide a control signal to the sweep generator to vary/reduce the sweep rate; when the output signal from the sampling phase detector comprises a DC-voltage, indicating phase lock to the selected frequency, or when the time interval between subsequent pulses from the comparator (detecting the signals from the phase detector), is sufficiently long, (Δf_{c} small enough) establishing that phase lock has been achieved; switching off the sweep.

In one implementation, relevant to the case when the phase detector does not have a sufficient bandwidth, providing a supplementary control signal to the sweep generator, to the loop filter and to the storing means to assure that the selected frequency harmonic is found despite there being no output signal (possible to detect by the comparator) from the phase detector.

It is an advantage of the invention that phase lock to a selected frequency or to a selected frequency harmonic can be achieved particularly in a few microseconds time, most particularly within approximately two µs.

### BRIEF DESCRIPTION OF THE DRAWINGS

The invention will in the following be more thoroughly described, in a non-limiting manner, and with reference to the accompanying drawings, in which:
- Fig. 1: is a block diagram particularly illustrating a first embodiment of the invention,
- Fig. 2: is a block diagram illustrating a second embodiment of the invention including supplementary control means for a narrow-band phase detector,
- Fig. 3: is an embodiment differing slightly from the embodiment of Fig. 2,
- Fig. 4: is a diagram illustrating variation in output signal from the phase detector as a function of the sweep rate,
- Fig. 5: is a diagram illustrating the VCO frequency as a function of the VCO voltage,
- Fig. 6: schematically illustrates an example on an integrating loop filter that can be used,
- Fig. 7: schematically illustrates the adding means according to one implementation of the invention, and
- Fig. 8: is a schematical flow diagram illustrating the phase lock procedure according to one implementation of the present invention.

### DETAILED DESCRIPTION OF THE INVENTION

According to the invention a reference frequency f_{ref} is input to a phase detector 1 to lock VCO 5 in a phase loop to a selected harmonic of the reference frequency. In general terms, the VCO 5 is first driven, coarsely, using a first (coarse) control voltage V_{control}, to a frequency which is somewhat lower (here; it could alternatively have been higher, then instead sweeping downwards) than the selected or desired frequency, particularly frequency harmonic of a reference frequency. A voltage sweep is then added by sweep generator 8 to the first control voltage. This will drive the VCO frequency towards the selected frequency harmonic. The frequency difference between the selected or desired frequency harmonic and the VCO frequency output is detected as Δf_{c}, i.e. the error frequency, by the comparator 7 used to provide distinct "switches", and a retriggerable mono-stable gate 8 is used to provide sufficiently long and reproducible pulses. The Δf_{c} value is used to control the sweep rate such that it will decrease as the VCO frequency approaches the selected frequency harmonic. When the VCO frequency is sufficiently close to the selected frequency, such that the phase loop has locked the VCO, the sweep is completely switched off.

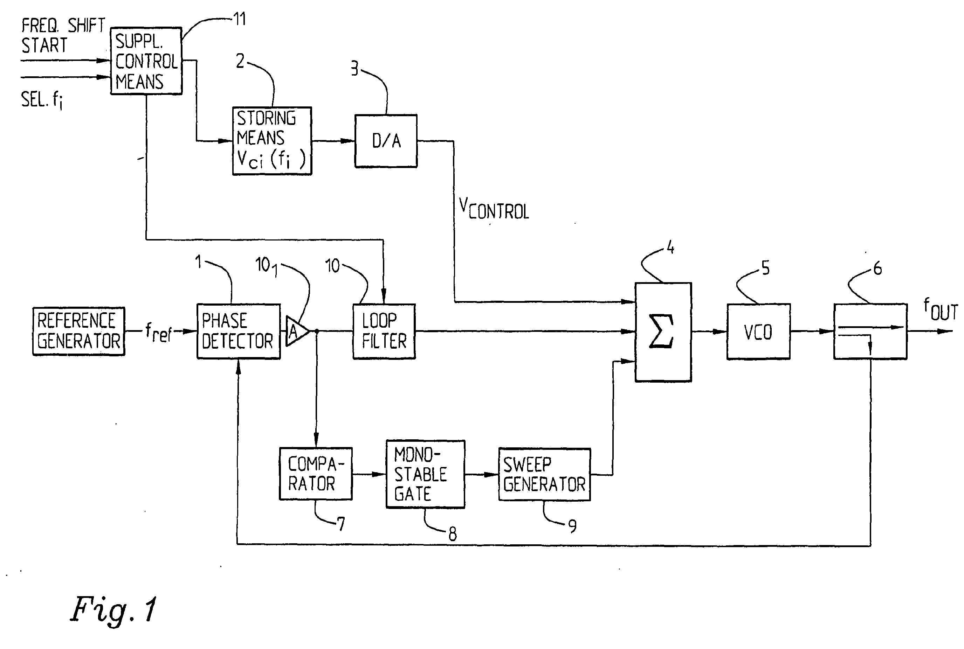

A first implementation is schematically illustrated in the block diagram of Fig. 1. It is supposed that a particular frequency harmonic fᵢ is selected which is a harmonic of the reference frequency f_{ref} which is input to a phase detector 1 from a reference generator. Supplementary control means 11 are used to control the loop filter 10, to switch on and off the integrating functionality thereof, and the signal frequency shift start triggers the initiation of a frequency shifting procedure, or a phase lock procedure. Information about the selected frequency harmonic fᵢ is used to find the relevant control voltage V_{control} in storing means 2 which will drive the VCO to a frequency that differs from the selected frequency harmonic fᵢ by a given value Δf. It is supposed that values for first control voltages relevant for each available frequency harmonic are stored in storing means 2. This is supposed to have been done at an earlier stage and the storing means 2 contains the first control voltages for all the frequencies to which the VCO 5 should be able to lock. Since the VCO 5 has an output power which is different for different frequencies, the loop gain will depend on the VCO frequency. In order to obtain a total loop bandwidth which is the same for all harmonics of the reference frequency to which the VCO should be possible to lock, it is required that an amplification control is used. From the storing means 2, which contains the first coarse control voltages for each frequency harmonic, a digital to analog conversion is performed in D/A-converter 3.

In an advantageous implementation a sampling phase detector 1 is used. This gives a lower phase noise than if a phase detector which is not sampling would be used. For a sampling phase detector it is required that the first control voltage is well defined and that a voltage sweep is used to drive the VCO within the loop bandwidth. Upon initiation of the phase lock procedure or frequency shifting, the voltage contributions from loop filter 10 and sweep generator 9 should be zero, or alternatively they should assume constant, known values.

As the first control voltage is applied, the sweep generator 9 starts a sweep with a constant sweep rate (V/s). When the sweep control detects a signal from the phase detector 1, i.e. that the VCO output frequency approaches the selected frequency harmonic fᵢ, the sweep rate is gradually reduced until the phase loop locks the VCO 5. When the VCO is locked, the sweep is completely switched off, and the frequency shift is completed. By reducing the sweep rate, the risk of missing (passing) the selected frequency harmonic during the sweep is reduced, and the risk of locking to the wrong frequency harmonic is also reduced.

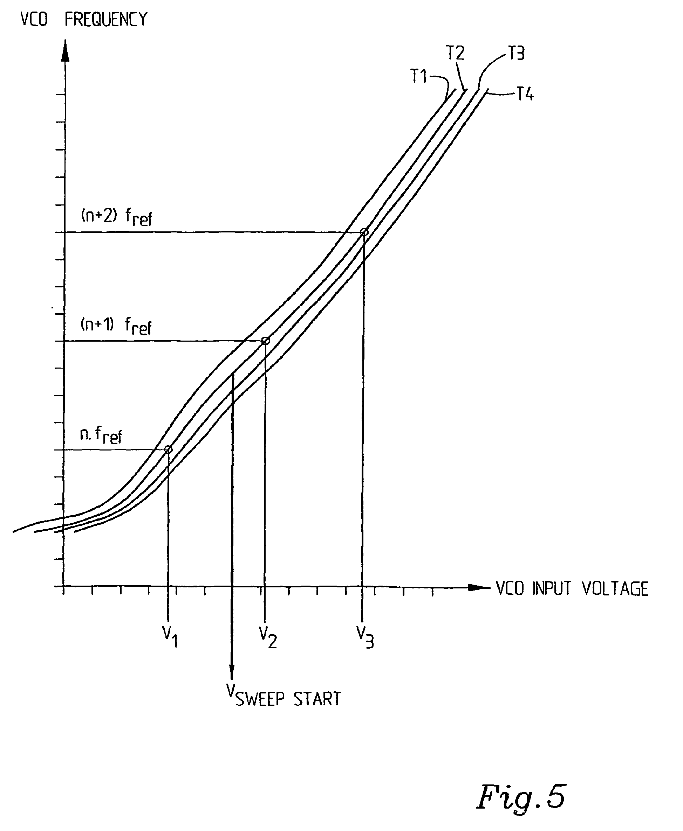

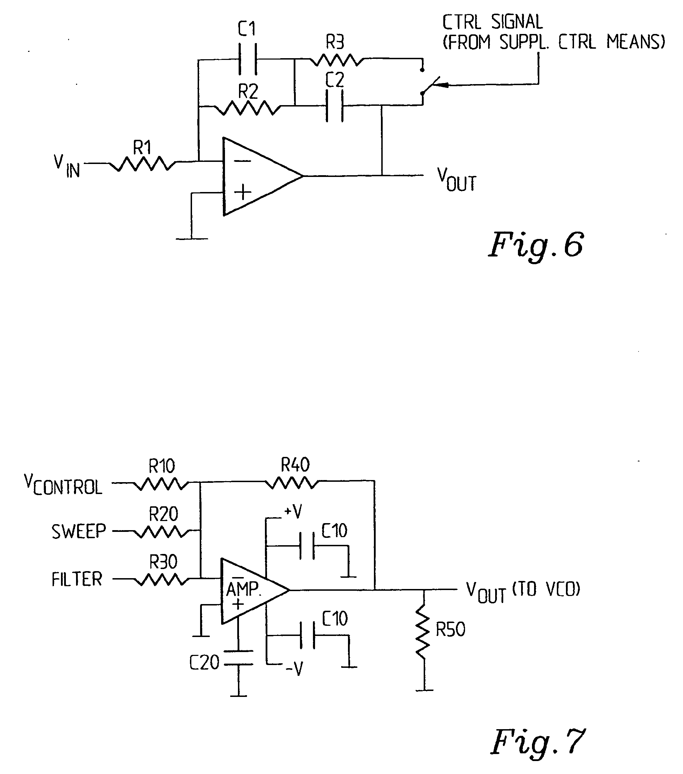

As a sampled phase detector is used the provision of a first coarse control voltage is required. Moreover, in a particular implementation an integrating loop filter 10 is used, i.e. a loop filter with a integrating functionality. The supplementary control means 11 provide a signal to the filter to indicate when the integrating functionality is to be switched on/off. In Fig. 1 loop amplifier 10₁ is illustrated as a separate element between the phase detector 1 and the loop filter 10. The amplifying functionality can however also be included in the filter 10, or vice versa, An example on such a filter is more thoroughly described in Fig. 6 below. One of the reasons for using an integrating loop filter is to enable discharging of the sweep voltage between subsequent frequency shifts or lockings to different frequency harmonics. During discharging, the integrating loop filter is used to compensate for the reduced contribution from the sweep to the assumed tuning voltage. According to the invention the first control voltage output from the D/A-converter 3 will control the VCO 5 such that it will be driven to oscillate Δf₁, for example 50 MHz, below/over the selected frequency harmonic. It should be clear that the value 50 MHz only is given as one specific example, the main thing being that Δf₁ is so much lower/higher than the selected frequency harmonic itself that the control voltage on which the sweep voltage is superimposed will not simply pass, and hence not lock the VCO to, the selected frequency harmonic. It should also be clear that Δf₁ depends on the frequencies used, on the amount that subsequent frequency harmonics differ from one another etc. Δf₁ has to be smaller than the frequency difference between subsequent harmonics, preferably as close as possible to the selected frequency without running the risk of sweeping past the selected harmonic.

The inventive concept is applicable to in principle any frequency, also to very high frequencies, such as e.g. several GHz or more than that, then, however, how high the frequencies can be will be given by how small circuits it is possible to build, otherwise there is no limitation.

The sweep functionality comprises a transistor through which the current is driven. The current through that transistor is used to charge a capacitor. A constant current through the transistor will give a linear voltage increase across the capacitor.

In one implementation the frequency shift or the phase lock to a selected frequency harmonic will function as follows. First the loop filter 10 is to be switched from an integrating filter to a filter having a limited amplification at DC. Some time is required in order to allow for discharging of the capacitor of the loop filter, cf. C2 in Fig. 6 below. When the loop filter is discharged, the relevant (for the selected fᵢ) first control voltage (found in the storing means 2) which also is denoted a coarse voltage, will be applied. As referred to above it is selected in such a manner that the VCO frequency will be Δf₁ below/over the frequency harmonic to which the VCO should be locked. Since the VCO is temperature dependent, it may be necessary to calibrate the first control voltage to a value that takes the temperature dependence into account. A sweep is subsequently initiated by the sweep generator 9. The activation may be provided through closure of a sweep switch. The fixed sweep is superimposed or added to the first control voltage V_{control,} V_{ci}. When approaching the bandwidth of the sampling phase detector 1, a second, varying frequency difference is detected, which also may be denoted an error frequency Δf_{c}. This signal is detected after the input amplifier 10₁. A comparator 7 is used to detect pulses from the phase detector and to provide distinct switching and a retriggerable, monostable gate 8 is used to provide pulses which are sufficiently long and reproducible. As the varying second frequency, the frequency Δf_{c}, decreases, also the sweep rate will be decreased. In that manner the risk of sweeping past the selected frequency harmonic is considerably reduced. Eventually the selected frequency harmonic will fall within the bandwidth of the loop, i.e. Δf_{c} will be so small, that the VCO will be locked to the reference frequency. When the VCO finally is locked, the integrating functionality of the loop filter 10 is again switched on (the integrating functionality always has to be switched off during a voltage sweep), and the phase lock procedure is completed. The filter will now compensate for the sweep discharge, which is necessary in order for it to be prepared for the subsequent phase locking procedure and the subsequent frequency shift.

According to the invention it is supposed that the VCO characteristic is detected before initiation of any phase lock/frequency shift procedure in order to find the appropriate control voltages to be stored in the storing means 2. Through manually applying a control voltage or a coarse voltage to the VCO, it gets possible to establish the VCO characteristics at different temperatures. Data is then stored into the storing means 2 so that the first coarse control voltages will correspond to and differ from the frequencies (harmonics) by a given value differing to a certain extent from the respective frequency harmonics. During this measurement the loop should be closed to avoid any erroneous contributions to the adding means, for example due to offset voltages.

In a particular implementation a signal is used to indicate that/when the fixed sweep should be switched off. It is done after a detection from the monostable gate 8. Subsequently the time period between two pulses from the monostable gate is measured. When the time period is longer than a given, predetermined value, the sweep rate is reduced. When there is no pulse within the above mentioned time interval, it is supposed that the frequency difference is so small that the frequency is within the bandwidth of the loop, and the loop will lock the VCO. Then there is no need for any further sweeps but instead the integrating functionality of the loop filter is switched on, and the frequency shift is concluded.

The modulation sensitivity of the VCO is generally different for different frequency harmonics. The same voltage sweep will give different sweep rate in MHz/µs, which is a result of the variation in modulation sensitivity. This means, that different frequency harmonics will be more or less easy to "detect", i.e. the risk of sweeping past them, differs. However, in an advantageous implementation a phase detector sampler having a large bandwidth is used. It will provide an earlier detection to indicate switch off of the fixed sweep, which as such reduces the risk of missing a frequency harmonic during a sweep. It is also possible to reduce the sweep rate for all frequency harmonics. Then, however, the frequency shift procedure will be somewhat slower, but this might be compensated for by selecting the first control voltage to be closer to the selected frequency harmonic already from the beginning. Still further it would be possible to implement different sweep rates for the different frequency harmonics; such a solution would however be somewhat more complicated. It is also possible to select the sweep rate in respect of the comparator threshold value and adjust the amplification such that the risk to sweep past a frequency harmonic without providing for locking is reduced.

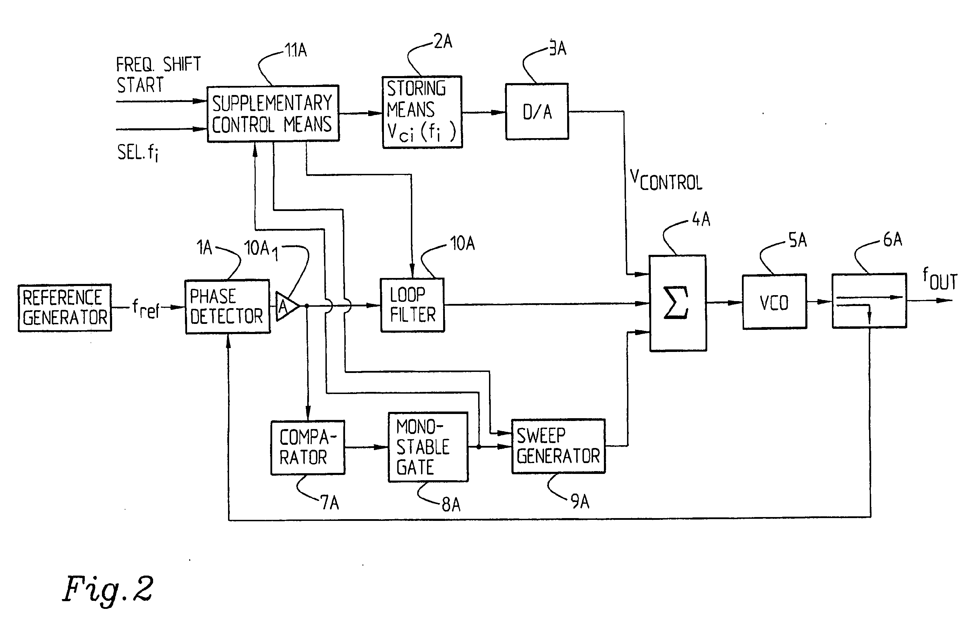

In the embodiment of Fig. 1, supposing that the phase detector has a large bandwidth, it is not necessary to use a fixed sweep rate at the start of the frequency shift. In the embodiment of Fig. 2, however, it is supposed that the phase detector does not have a bandwidth which is sufficiently large. The situation might occur that there is no output signal from the phase detector to the loop filter detectable by the comparator even if there should be one. A control mechanism (supplementary control means) 11A is then needed in order to provide the sweep generator 9A with a signal also when there is no signal from the comparator 7A until a signal actually is detected at the monostable gate 8A. Subsequently, from that point, the sweep or the sweep rate is controlled by a signal that stepwise changes the sweep rate (or continuously). In order to provide for such an additional control functionality, supplementary control means 11A are provided, to which information about the selected frequency harmonic fᵢ is provided. A signal is then provided to the loop filter 10A (via amplifier 10A₁), to the sweep generator 9A and, of course, to the storing means 2A. A feedback is also provided from after monostable gate 8A to the supplementary control means. The other components function in a manner similar to that described with reference to Fig. 1, and they bear the same reference numerals with the addition of a reference "A". Also in the embodiment of Fig. 2, it is a requirement that the integrating functionality of the loop filter 10A can be switched off, which is handled by the supplementary control means 11A (cf. Fig. 1).

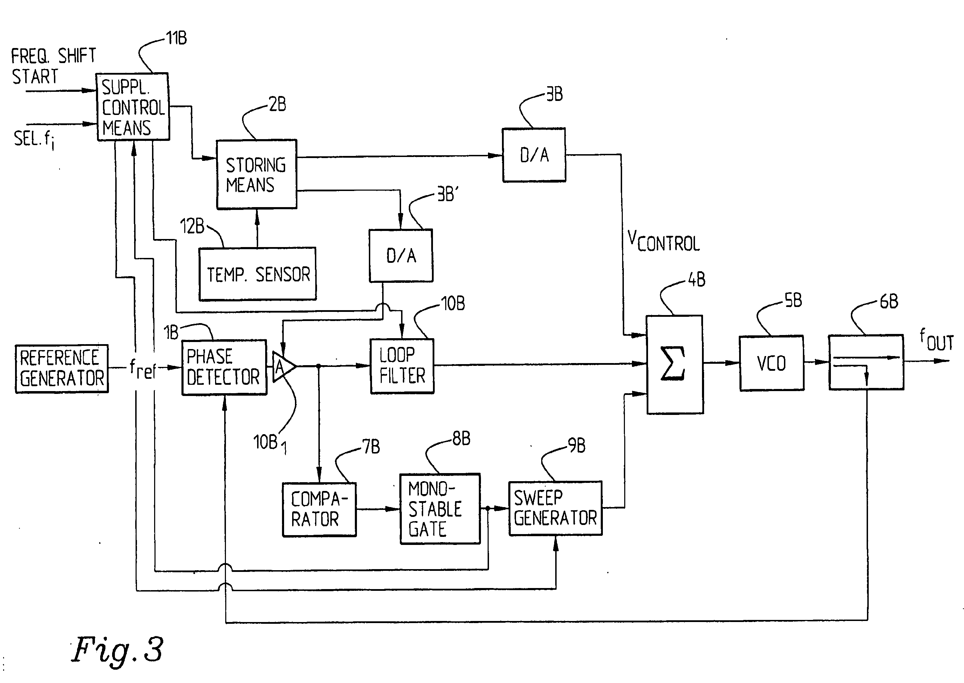

Fig. 3 is an illustration of an embodiment which is very similar to that of Fig. 2. However, the supplementary control means 11B and the storing means 2B are connected to each a D/A-converter 3B, 3B' respectively. The D/A converter 3B' is used to control the loop gain. In this embodiment the supplementary control signalling is provided to the loop filter 10B, to the sweep generator 9B, as in Fig. 2. In the figure also temperature sensing means 12B as discussed earlier are provided which are used for finding and storing the values of the respective control voltages, and also for finding the appropriate first coarse voltage when performing a new frequency shift. An input signal is provided to the supplementary control means 11B indicating the selected frequency harmonic. The signal "frequency shift start" is used to initiate the frequency shift. In the remaining aspects the functioning is similar to that described above with reference to Fig. 2, the corresponding numerals being provided with a letter "B".

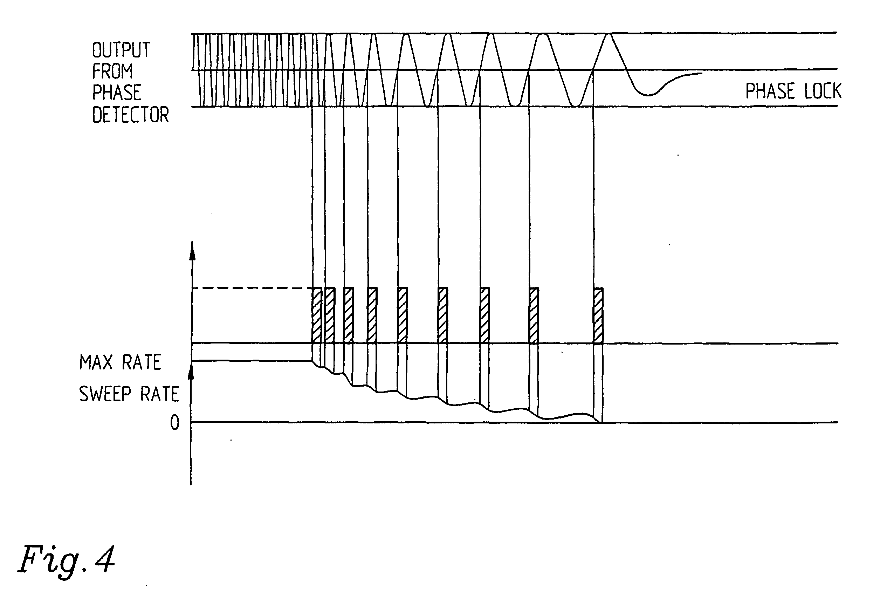

Fig. 4 is a diagram illustrating the output from the phase detector as a function of the sweep rate. For maximum sweep rate the monostable gate will trigger all the time (there is a logical one all the time). However at a given point (when Δf_{c} falls below a given value) an indication signal is provided indicating to the sweep generator that it should reduce the sweep rate. As the frequency is reduced, even if the sweep gets slower and slower, the output approaches a DC voltage, i.e. when the second varying frequency difference approaches zero, a phase lock condition will finally be acquired.

Fig. 5 is a schematical diagram illustrating VCO frequency as a function of the VCO voltage. In the figure three different frequency harmonics, n x f_{ref}, (n+1) x f_{ref} and (n+2) x f_{ref}, are indicated. Here it is supposed that the reference frequency is f_{ref} and available frequency harmonics, i.e. the frequency harmonics to which the VCO can lock, are multiples n, n+1, and n+2 of f_{ref}. The different lines indicate the frequency as a function of the voltage respectively for different temperatures, here T1, T2, T3, T4. It is indicated when the sweep voltage is initiated to ensure phase lock to frequency harmonic n+1 (x f_{ref}). It is then swept up to V₂ for a temperature T2. (V₁ and V₂ are corresponding voltages for multiples (harmonics) n and n + 1). The relevant first control voltages of the respective harmonics are stored in the storing means.

In Fig. 6 one example on an integrating loop filter that can be used in the loop is illustrated. However, in order to provide for a disconnectable integrating functionality, a resistor can be connected in parallel with the capacitor C2 in order to limit amplification at low frequencies. The resistor is disconnected when the phase lock has been achieved. A control signal is provided from the supplementary control means to switch on/off the integrating functionality of the loop filter, i.e. a switch can be closed. Particularly an amplifier may be provided at the output of the sampler of the phase detector to control the loop gain and the bandwidth of the signal from the phase detector. The filter output is connected to one of the inputs of the adding means. Fig. 7 very schematically illustrates one example of an adding means to which is input the first coarse control voltage, the sweep voltage and the signal output from the filter. The output from the adding means is provided to the VCO. It should however be clear that this figure merely is illustrated as an example of a circuit solution, with resistors R10, R20, R30, R40, R50, capacitors C10, C10 and C20.

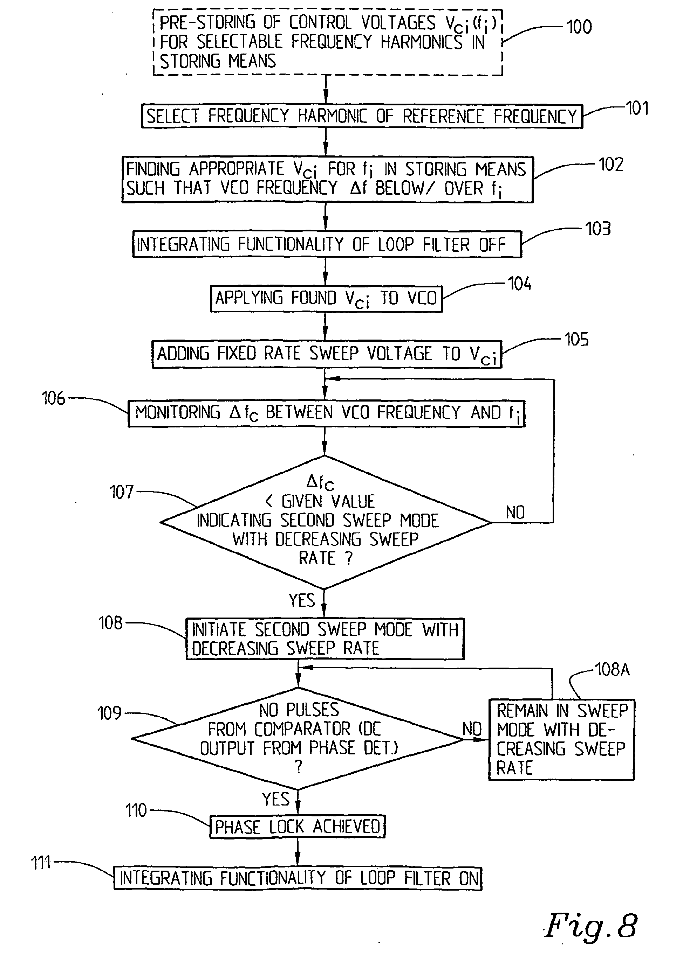

Fig. 8 is a very schematical flow diagram illustrating the procedure for phase locking the VCO to a selected frequency harmonic fᵢ, or for providing a frequency shift. It is supposed that pre-storing of appropriate first coarse control voltages V_{ci} (fᵢ) has been done in storing means for all the selectable or available frequency harmonics, 100. This step is indicated within dashed lines since it is done separately and the stored values can be used for every phase lock procedure for the respective available frequency components. Then it is supposed that the relevant frequency harmonic of the reference frequency is selected (input to the supplementary control means), 101. The appropriate V_{ci} for fᵢ is then found in the storing means such that the VCO frequency will be Δf below/over fᵢ, 102. The integrating functionality of the loop filter is then switched off, 103. The found control voltage V_{ci} is thereupon applied to the VCO via the adding means, 104. A voltage sweep with a fixed sweep rate is added to the control voltage, 105. The frequency difference Δf_{c} between the detected VCO frequency and fᵢ is then monitored, 106. If the Δf_{c} is not below a given value, it is proceeded with monitoring of Δf_{c} and the sweep is continued with the fixed sweep rate. If Δf_{c} is below the given value a sweep mode with a lower sweep rate should be used, 107, 108, finally it will be established if a DC-voltage is output from a phase detector, (no pulses from comparator) 109. If not, the sweep rate is further decreased, 108A, until finally a DC voltage is output from the phase detector, indicating that phase lock has been achieved, 110, to the selected frequency harmonic. More specifically, according to an alternative to step 109, the time interval that lapses between subsequent pulses from the comparator is detected, and when that time interval is detected to be sufficiently long (i.e. Δf_{c} small enough), it is considered that phase lock has been achieved. Step 107 is optional, preferably only Δf_{c} is detected/monitored, and the sweep rate reduced in dependence thereof, e.g. continuously or even more particularly to a smaller and smaller extent as Δf_{c} gets smaller. When phase lock has been achieved (110), the integrating functionality of the loop filter is switched on, 111.

In alternative implementations, instead of starting with a frequency that is lower than the selected frequency (and differs therefrom by a given value) it is also possible to start with a frequency that is higher than the selected frequency harmonic and then sweep downwards, i.e. by adding a negative voltage in the adding means.

It should be clear, of course, that the invention is not limited to the specifically illustrated embodiments, but that it can be varied in a number of ways without departing from the scope of the appended claims. If a stepwise reduction of the sweep rate is implemented, the steps may be longer at the beginning, and shorter at the end etc. Different modes may be used, a first mode with longer steps, a second mode with shorter steps when the Δf_{c} value assumes a given amount, etc.

## Claims

1. An arrangement for phase locking of a Voltage Controlled Oscillator (VCO) (5;5A;5B) to a selected frequency harmonic among a number of predetermined or available frequencies, harmonics, comprising a reference generator for generating a reference frequency, a phase lock loop for producing an output signal in response to the input reference frequency, said phase lock loop comprising a phase detector (1;1A;1B), a loop filter (10;10A;10B), said VCO (5;5A;5B), adding means (4;4A;4B) and a power splitter (6;6A;6B), a sweep generator (9;9A;9B) further being provided, the arrangement further comprising or being associated with storing means (2;2A;2H) for storing information about, for each selectable or available frequency harmonic, a first, coarse, control voltage providing a VCO frequency output which is lower/higher than, and differs from the selected frequency, harmonic by a given value (Δf₁), wherein the sweep generator (9;9A;9B) adds, superimposes, a controllable sweep voltage to/on the first control voltage at least until a varying, second difference (Δf_{c}) between the output VCO frequency and the selected frequency harmonic reaches a given value,
**characterized in**
**that** monitoring/detecting means are provided for detecting the varying, second difference (Δf_{c}) between the selected frequency harmonic and the VCO output frequency, and in that sweep generator control means are provided for reducing the sweep rate until the VCO is phase locked to the selected frequency harmonic, and in that it comprises an integrating loop filter (10;10A;10B) for which the integrating functionality is switched off when a frequency shift is started, and switched on when phase lock is achieved.

2. An arrangement according to claim 1,
**characterized in**
**that** the monitoring/detecting means provides for a detection at discrete intervals of the varying, second difference (Δt_{c}), between the selected frequency harmonic and the VCO output frequency.

3. An arrangement according to claim 1,
**characterized in**
**that** the monitoring/detecting means provides for a continuous detection of the varying, second frequency difference (Δf_{c}), between the selected frequency harmonic and the VCO output frequency.

4. An arrangement according to claim 1 or 2,
**characterized in**
**that** the sweep generator control means continuously reduces the sweep rate in dependence of the detection of the varying, second frequency difference (Δf_{c}).

5. An arrangement according to claim 1,2 or 3,
**characterized in**
**that** that the sweep generator control means stepwise reduces the sweep rate.

6. An arrangement according to any one of the preceding claims,
**characterized in**
**that** the phase locking loop is a sampled phase-lock loop (SPLL) i.e. that the phase detector (1;1A;1B) is a sampling phase detector.

7. An arrangement according to any one of claims 1-5,
**characterized in**
**that** the phase detector is a non-sampling phase detector.

8. An arrangement according to any one of the preceding claims,
**characterized in**
**that** the sweep generator is disconnected, switched off, when the VCO is phase locked.

9. An arrangement according to anyone of the preceding claims,
**characterized in**
**that** a DC voltage is detected as output from the phase detector (1;1A;1B) when phase lock has been achieved.

10. An arrangement according to any one of the preceding claims,
**characterized in**
**that** the control means comprising supplementary control means (11;11A;11B) provide for a continuous sweep from the sweep generator also when the comparator is not able to detect a signal from the phase detector.

11. An arrangement according to any one of the preceding claims,
**characterized in**
**that** the phase detector is narrow-banded.

12. An arrangement according to any one of claims 1-10,
**characterized in**
**that** the supplementary control means (11;11A;11B) provides control signals to the loop filter (10;10A;10B) disposed between the phase detector (1;1A;1B) and the adding means to control activation/deactivation of the integrating functionality of the loop filter.

13. An arrangement according to any one of the preceding claims,
**characterized in**
**that** the signal from the phase detector detected via a comparator (7;7A;7B) and a monostable gate (8;8A;8B) is input to the sweep generator (9;9A;9B).

14. An arrangement according to claim 13,
**characterized in**
**that** a signal pulse from the monostable (8;8A;8B) gate is detected via a first signal indicating that a first fixed sweep rate is to be replaced by a second sweep rate, the rate of which is continuously or stepwise reduced as the frequency difference is reduced.

15. An arrangement according to any one of the preceding claims,
**characterized in**
**that** a D/A-converter (3;3A;3B) is disposed between the storing means (2;2A;2B) and the adding means (4;4A;4B) providing the input signal to the VCO (5;5A;SB).

16. A method for locking the phase of a voltage controlled oscillator to a selected frequency harmonic among a number of predetermined, available, frequency harmonics, comprising the steps of:
- finding, in storing means, a first control voltage associated with the selected frequency harmonic which has a value such that the frequency of the VCO will be lower/higher than, and differ from, the selected frequency harmonic by a given first frequency (Δf₁),
- applying the found first control voltage,
- adding, superimposing, a sweep voltage to the first control voltage, at least until a varying, second difference (Δf_{c}) between the output VCO frequency and the selected frequency harmonic reaches a given value,
**characterized in**
**that** it further comprises the steps of:
- detecting/monitoring the varying, second frequency difference, error frequency, (Δf_{c}) between the VCO frequency and the selected frequency harmonic,
- controlling the rate of the sweep voltage at least at detection of a predetermined frequency difference by reducing it until the VCO is phase locked to the selected frequency harmonic, using an integrating switch-off able loop filter, and in that the integrating functionality of the loop filter is switched off when a frequency shift is started, and switched on when phase lock is achieved.

17. A method according to claim 16,
**characterized in**
**that** it comprises the step of:
- monitoring the second, varying frequency difference (Δf_{c}) continuously.

18. A method according to claim 16,
**characterized in**
**that** it comprises the step of:
- establishing the second, varying frequency difference (Δf_{c}) instantly at discrete time intervals.

19. A method according to claim 16 or 17,
**characterized in**
**that** it comprises the step of:
- reducing the rate of the sweep continuously or stepwise.

20. A method according to any one of claims 16-19,
**characterized in**
**that** it comprises the steps of:
- providing a reference signal with the selected frequency to the phase detector,
- finding the first control voltage in storing means,
- converting in a D/A-converter the output from the storing means,
- applying the first control voltage to the VCO,
- detecting the second, varying, frequency difference (Δf_{c}) from the sampling phase detector,
- using said frequency difference signal to control a sweep generator,
- when the output signal from the sampling phase detector comprises a DC-voltage, or when the time period, that lapses between two consecutive pulses from a comparator, detecting pulses from the phase detector, is long enough, indicating phase lock to the selected frequency harmonic, the sweep is switched off.

21. A method according to claim 20,
**characterized in**
**that** it comprises the step of:
- providing control signal from a supplementary control means to the sweep generator, to the loop filter of the phase lock loop and to the storing means to assure that the selected frequency harmonic is found despite it not being possible to detect any output signal from the phase detector.

22. A method according to any one of claims 16-21,
**characterized in**
**that** activation/ deactivation of the integrating functionality of the loop filter is controlled by a supplementary control means.

## Patentansprüche

1. Anordnung zum Phasenverriegeln eines spannungsgesteuerten Oszillators (VCO) (5; 5A; 5B) auf eine gewählte Frequenzharmonische unter einer Anzahl vorbestimmter oder verfügbarer Frequenzen, Harmonischer, umfassend einen Referenzgenerator zum Erzeugen einer Referenzfrequenz, eine Phasenverriegelungsschleifeneinheit zum Produzieren eines Ausgangssignals ansprechend auf die Eingangsreferenzfrequenz, wobei die Phasenverriegelungsschleifeneinheit einen Phasendetektor (1; 1A; 1B), ein Schleifenfilter (10; 10A; 10B), den VCO (5; 5A; 5B), eine Addiereinrichtung (4; 4A; 4B) und einen Leistungsspalter (6; 6A; 6B) umfasst, und ferner ein Kippgenerator (9; 9A; 9B) bereitgestellt ist, wobei die Anordnung ferner eine Speichereinrichtung (2; 2A; 2B) umfasst zum Speichern von Information über, für jede wählbare oder verfügbare Frequenzharmonische, eine erste, grobe Steuerspannung, eine VCO-Frequenzausgabe bereitstellend, die niedriger/höher ist als die gewählte Frequenz, Harmonische und sich von dieser um einen gegebenen Wert (Δf₁) unterscheidet, oder mit der Speichereinrichtung verknüpft ist, wobei der Kippgenerator (9; 9A; 9B) eine steuerbare Kippspannung zu der ersten Steuerspannung addiert, oder eine steuerbare Kippspannung der ersten Steuerspannung überlagert, mindestens bis eine variierende, zweite Differenz (Δf_{c}) zwischen der Ausgangs-VCO-Frequenz und der gewählten Frequenzharmonischen einen gegebenen Wert erreicht,
**dadurch gekennzeichnet,**
**dass** Überwachungs-/Erfassungseinrichtungen bereitgestellt sind zum Erfassen der variierenden, zweiten Differenz (Δf_{c}) zwischen der gewählten Frequenzharmonischen und der VCO-Ausgangsfrequenz, und
**dass** Kippgeneratorsteuereinrichtungen bereitgestellt sind zum Reduzieren der Kipprate, bis der VCO auf die gewählte Frequenzharmonische phasenverriegelt ist, und
**dass** sie ein integrierendes Schleifenfilter (10; 10A; 10B) umfasst, dessen Integrierfunktionalität abgeschaltet ist, wenn eine Frequenzverschiebung gestartet ist, und angeschaltet ist, wenn eine Phasenverriegelung erreicht ist.

2. Anordnung gemäß Anspruch 1, **dadurch gekennzeichnet, dass** die Überwachungs-/Erfassungseinrichtung eine Erfassung bei diskreten Intervallen der variierenden, zweiten Differenz (Δf_{c}), zwischen der gewählten Frequenzharmonischen und der VCO-Ausgangsfrequenz, bereitstellt.

3. Anordnung gemäß Anspruch 1, **dadurch gekennzeichnet, dass** die Überwachungs-/Erfassungseinrichtung eine kontinuierliche Erfassung der variierenden, zweiten Differenz (Δf_{c}), zwischen der gewählten Frequenzharmonischen und der VCO-Ausgangsfrequenz, bereitstellt.

4. Anordnung gemäß Anspruch 1 oder 2, **dadurch gekennzeichnet, dass** die Kippgeneratorsteuereinrichtung kontinuierlich die Kipprate in Abhängigkeit der Erfassung der variierenden, zweiten Frequenzdifferenz (Δf_{c}) reduziert.

5. Anordnung gemäß Anspruch 1, 2 oder 3, **dadurch gekennzeichnet, dass** die Kippgeneratorsteuereinrichtung schrittweise die Kipprate reduziert.

6. Anordnung gemäß einem der vorherigen Ansprüche, **dadurch gekennzeichnet, dass** die phasenverriegelnde Schleifeneinheit eine abgetastete Phasenverriegelungsschleifeneinheit (SPLL) ist, d.h. dass der Phasendetektor (1; 1A; 1B) ein Abtastphasendetektor ist.

7. Anordnung gemäß einem der Ansprüche 1-5, **dadurch gekennzeichnet, dass** der Phasendetektor ein Nicht-Abtastphasendetektor ist.

8. Anordnung gemäß einem der vorherigen Ansprüche, **dadurch gekennzeichnet, dass** der Kippgenerator getrennt, abgeschaltet ist, wenn der VCO phasenverriegelt ist.

9. Anordnung gemäß einem der vorherigen Ansprüche, **dadurch gekennzeichnet, dass** eine Gleichspannung als Ausgabe von dem Phasendetektor (1; 1A; 1B) erfasst ist, wenn eine Phasenverriegelung erreicht worden ist.

10. Anordnung gemäß einem der vorherigen Ansprüche, **dadurch gekennzeichnet, dass** die Zusatzsteuereinrichtungen (11; 11A; 11B) umfassende Steuereinrichtungen ein kontinuierliches Kippen von dem Kippgenerator bereitstellen, auch wenn der Komparator nicht fähig ist, ein Signal von dem Phasendetektor zu erfassen.

11. Anordnung gemäß einem der vorherigen Ansprüche, **dadurch gekennzeichnet, dass** der Phasendetektor schmalbandig ist.

12. Anordnung gemäß einem der Ansprüche 1-10, **dadurch gekennzeichnet, dass** die Zusatzsteuereinrichtung (11; 11A; 11B) Steuersignale dem zwischen dem Phasendetektor (1; 1A; 1B) und der Addiereinrichtung angeordneten Schleifenfilter (10; 10A; 10B) bereitstellt, um eine Aktivierung/Deaktivierung der Integrierfunktionalität des Schleifenfilters zu steuern.

13. Anordnung gemäß einem der vorherigen Ansprüche, **dadurch gekennzeichnet, dass** das über einen Komparator (7; 7A; 7B) und ein monostabiles Gatter (8; 8A; 8B) erfasste Signal von dem Phasendetektor an den Kippgenerator (9; 9A; 9B) eingegeben ist.

14. Anordnung gemäß Anspruch 13, **dadurch gekennzeichnet, dass** ein Signalpuls von dem monostabilen Gatter (8; 8A; 8B) erfasst ist über ein erstes Signal, das anzeigt, dass eine erste feste Kipprate durch eine zweite Kipprate ersetzt werden soll, deren Rate kontinuierlich oder schrittweise reduziert ist, wie die Frequenzdifferenz reduziert ist.

15. Anordnung gemäß einem der vorherigen Ansprüche, **dadurch gekennzeichnet, dass** ein D/A-Wandler (3; 3A; 3B) zwischen der Speichereinrichtung (2; 2A; 2B) und der das Eingangssignal zu dem VCO (5; 5A; 5B) bereitstellenden Addiereinrichtung (4; 4A; 4B) angeordnet ist.

16. Verfahren zum Verriegeln der Phase eines spannungsgesteuerten Oszillators auf eine gewählte Frequenzharmonische unter einer Anzahl vorbestimmter, verfügbarer, Frequenzharmonischer, die Schritte umfassend zum:
- Finden, in Speichereinrichtungen, einer mit der gewählten Frequenzharmonischen verknüpften ersten Steuerspannung, die einen Wert hat, so dass die Frequenz des VCO niedriger/höher sein wird als die gewählte Frequenzharmonische und sich von dieser um eine gegebene erste Frequenz (Δf₁) unterscheidet,
- Anwenden der gefundenen ersten Steuerspannung,
- Addieren, Überlagern einer Kippspannung zu der ersten Steuerspannung mindestens bis eine variierende, zweite Differenz (Δf_{c}) zwischen der Ausgangs-VCO-Frequenz und der gewählten Frequenzharmonischen einen gegebenen Wert erreicht,
**dadurch gekennzeichnet, dass** es ferner die Schritte umfasst zum:
- Erfassen/Überwachen der variierenden, zweiten Frequenzdifferenz, Fehlerfrequenz, (Δf_{c}) zwischen der VCO-Frequenz und der gewählten Frequenzharmonischen,
- Steuern der Rate der Kippspannung mindestens bei Erfassung einer vorbestimmten Frequenzdifferenz durch Reduzieren davon, bis der VCO auf die gewählte Frequenzharmonische phasenverriegelt ist, mit Verwenden eines integrierenden abschaltfähigen Schleifenfilters, und dass die Integrierfunktionalität des Schleifenfilters abgeschaltet wird, wenn eine Frequenzverschiebung gestartet wird, und angeschaltet wird, wenn eine Phasenverriegelung erreicht wird.

17. Verfahren gemäß Anspruch 16, **dadurch gekennzeichnet, dass** es den Schritt umfasst zum:
- kontinuierlichen Überwachen der zweiten, variierenden Frequenzdifferenz (Δf_{c}).

18. Verfahren gemäß Anspruch 16, **dadurch gekennzeichnet, dass** es den Schritt umfasst zum:
- sofortigen Etablieren der zweiten, variierenden Frequenzdifferenz (Δf_{c}) zu diskreten Zeitintervallen.

19. Verfahren gemäß Anspruch 16 oder 17, **dadurch gekennzeichnet, dass** es den Schritt umfasst zum:
- kontinuierlichen oder schrittweisen Reduzieren der Rate des Kippens.

20. Verfahren gemäß einem der Ansprüche 16-19, **dadurch gekennzeichnet, dass** es die Schritte umfasst zum:
- Bereitstellen eines Referenzsignals mit der gewählten Frequenz an den Phasendetektor,
- Finden der ersten Steuerspannung in Speichereinrichtungen,
- Wandeln in einem D/A-Wandler der Ausgabe von den Speichereinrichtungen,
- Anwenden der ersten Steuerspannung auf den VCO
- Erfassen der zweiten, variierenden Frequenzdifferenz (Δf_{c}) von dem Abtastphasendetektor,
- Verwenden des Frequenzdifferenzsignals, um einen Kippgenerator zu steuern,
- wobei, wenn das Ausgabesignal von dem Abtastphasendetektor eine Gleichspannung umfasst, oder wenn die Zeitperiode, die zwischen zwei aufeinanderfolgenden Pulsen von einem Komparator, Pulse von dem Phasendetektor erfassend, lang genug ist, eine Phasenverriegelung auf die gewählte Frequenzharmonische anzeigend, das Kippen abgeschaltet wird.

21. Verfahren gemäß Anspruch 20, **dadurch gekennzeichnet, dass** es den Schritt umfasst zum:
- Bereitstellen eines Steuersignals von einer Zusatzsteuereinrichtung an den Kippgenerator, an das Schleifenfilter der Phasenverriegelungsschleifeneinheit und an die Speichereinrichtungen, um sicherzustellen, dass die gewählte Frequenzharmonische gefunden wird, ungeachtet dessen, dass es nicht möglich ist, ein Ausgangssignal von dem Phasendetektor zu erfassen.

22. Verfahren gemäß einem der Ansprüche 16-21, **dadurch gekennzeichnet, dass** die Aktivierung/Deaktivierung der Integrierfunktionalität des Schleifenfilters durch eine Zusatzsteuereinrichtung gesteuert wird.

## Revendications

1. Agencement pour l'asservissement de phase d'un oscillateur commandé par tension (VCO) (5 ; 5A ; 5B) sur un harmonique de fréquence sélectionné parmi un certain nombre d'harmoniques de fréquence prédéterminés ou disponibles, comprenant un générateur de référence pour générer une fréquence de référence, une boucle d'asservissement de phase pour produire un signal de sortie en réponse à la fréquence de référence d'entrée, cette boucle d'asservissement de phase comprenant un détecteur de phase (1 ; 1A ; 1B), un filtre de boucle (10 ; 10A ; 10B), ledit VCO (5 ; 5A ; 5B), un moyen d'ajout (4 ; 4A ; 4B) et un diviseur de puissance (6 ; 6A ; 6B), un générateur de balayage (9 ; 9A ; 9B) étant en outre incorporé, l'agencement comprenant en outre un moyen de stockage (2 ; 2A ; 2B), ou étant en outre associé à ce dernier, pour stocker de l'information concernant, pour chaque harmonique de fréquence disponible ou pouvant être sélectionné, une première tension de commande grossière donnant une fréquence de sortie de VCO qui est supérieure / inférieure à l'harmonique de fréquence sélectionné, et diffère de celui-ci d'une valeur donnée (Δf₁), dans lequel le générateur de balayage (9 ; 9A ; 9B) ajoute, superpose, une tension de balayage pouvant être commandée, à / sur la première tension de commande au moins jusqu'à ce qu'une deuxième différence variable (Δf_{c}) entre la fréquence de VCO de sortie et l'harmonique de fréquence sélectionné atteigne une valeur donnée,
**caractérisé en ce que**
des moyens de surveillance / détection sont incorporés pour détecter la deuxième différence variable (Δf_{c}) entre l'harmonique de fréquence sélectionné et la fréquence de sortie du VCO, et **en ce que** des moyens de commande de générateur de balayage sont incorporés pour réduire la vitesse de balayage jusqu'à ce que le VCO soit asservi en phase sur l'harmonique de fréquence sélectionné, et **en ce qu'**il comprend un filtre de boucle intégrateur (10 ; 10A ; 10B) pour lequel la fonctionnalité d'intégration est désactivée lorsqu'un décalage de fréquence est commencé, et est activée lorsque l'asservissement de phase est réalisé.

2. Agencement selon la revendication 1,
**caractérisé en ce que**
les moyens de surveillance / détection effectuent une détection, à des intervalles discrets, de la deuxième différence variable (Δf_{c}) entre l'harmonique de fréquence sélectionné et la fréquence de sortie du VCO.

3. Agencement selon la revendication 1,
**caractérisé en ce que**
les moyens de surveillance / détection effectuent une détection continue de la deuxième différence variable (Δf_{c}) entre l'harmonique de fréquence sélectionné et la fréquence de sortie du VCO.

4. Agencement selon la revendication 1 ou 2,
**caractérisé en ce que**
le moyen de commande de générateur de balayage réduit la vitesse de balayage de façon continue sous la dépendance de la détection de la deuxième différence de fréquence variable (Δf_{c}).

5. Agencement selon la revendication 1, 2 ou 3
**caractérisé en ce que**
le moyen de commande de générateur de balayage réduit pas à pas la vitesse de balayage.

6. Agencement selon l'une quelconque des revendications précédentes,
**caractérisée en ce que**
la boucle d'asservissement de phase est une boucle d'asservissement de phase échantillonnée (SPLL), c'est-à-dire que le détecteur de phase (1 ; 1A ; 1B) est un détecteur de phase à échantillonnage.

7. Agencement selon l'une quelconque des revendications 1 à 5,
**caractérisé en ce que**
le détecteur de phase est un détecteur de phase sans échantillonnage.

8. Agencement selon l'une quelconque des revendications précédentes,
**caractérisé en ce que**
le générateur de balayage est déconnecté, mis hors fonction, lorsque le VCO est asservi en phase.

9. Agencement selon l'une quelconque des revendications précédentes,
**caractérisé en ce que**
une tension continue est détectée en tant que signal de sortie du détecteur de phase (1 ; 1A ; 1B) lorsque l'asservissement de phase a été réalisé.

10. Agencement selon l'une quelconque des revendications précédentes,
**caractérisé en ce que**
le moyen de commande, comprenant un moyen de commande supplémentaire (11 ; 11A ; 11B), fait en sorte que le générateur de balayage effectue un balayage continu également lorsque le comparateur n'est pas capable de détecter un signal provenant du détecteur de phase.

11. Agencement selon l'une quelconque des revendications précédentes,
**caractérisé en ce que**
le détecteur de phase est à bande étroite.

12. Agencement selon l'une quelconque des revendications 1 à 10,
**caractérisé en ce que**
le moyen de commande supplémentaire (11 ; 11A ; 11B) fournit des signaux de commande au filtre de boucle (10 ; 10A ; 10B) disposé entre le détecteur de phase (1 ; 1A ; 1B) et le moyen d'ajout, pour commander l'activation / la désactivation de la fonctionnalité d'intégration du filtre de boucle.

13. Agencement selon l'une quelconque des revendications précédentes,
**caractérisé en ce que**
le signal provenant du détecteur de phase, détecté par l'intermédiaire d'un comparateur (7 ; 7A ; 7B) et d'une porte monostable (8 ; 8A ; 8B), est appliqué au générateur de balayage (9 ; 9A ; 9B).

14. Agencement selon la revendication 13,
**caractérisé en ce que**
une impulsion de signal provenant de la porte monostable (8 ; 8A ; 8B) est détectée par l'intermédiaire d'un premier signal indiquant qu'une première vitesse de balayage fixée doit être remplacée par une deuxième vitesse de balayage, la vitesse de ce balayage étant réduite de manière continue ou pas à pas au fur et à mesure que la différence de fréquence est réduite.

15. Agencement selon l'une quelconque des revendications précédentes,
**caractérisé en ce que**
un convertisseur N/A (3 ; 3A ; 3B) est disposé entre le moyen de stockage (2 ; 2A ; 2B) et le moyen d'ajout (4 ; 4A ; 4B) appliquant le signal d'entrée au VCO (5 ; 5A ; 5B).

16. Procédé pour asservir la phase d'un oscillateur commandé par tension sur un harmonique de fréquence sélectionné parmi un certain nombre d'harmoniques de fréquences disponibles, prédéterminés, comprenant les étapes consistant à:
- trouver, dans un moyen de stockage, une première tension de commande associée à l'harmonique de fréquence sélectionné qui a une valeur telle que la fréquence du VCO sera inférieure / supérieure à l'harmonique de fréquence sélectionné, et différera de celui-ci d'une première fréquence donnée (Δf₁),
- appliquer la première tension de commande trouvée,
- ajouter, superposer, une tension de balayage à la première tension de commande, au moins jusqu'à ce qu'une deuxième différence variable (Δf_{c}) entre la fréquence de sortie du VCO et l'harmonique de fréquence sélectionné atteigne une valeur donnée,
**caractérisé en ce qu'**il comprend en outre les étapes consistant à :
- détecter / surveiller la deuxième différence de fréquence variable, qui est une fréquence d'erreur, (Δf_{c}) entre la fréquence du VCO et l'harmonique de fréquence sélectionné,
- commander la vitesse de variation de la tension de balayage au moins à la détection d'une différence de fréquence prédéterminée, en la réduisant jusqu'à ce que le VCO soit asservi en phase sur l'harmonique de fréquence sélectionné, en utilisant un filtre de boucle intégrateur pouvant être désactivé, et **en ce que** la fonctionnalité d'intégration du filtre de boucle est désactivée lorsqu'un décalage de fréquence est commencé, et est activée lorsque l'asservissement de phase est réalisé.

17. Procédé selon la revendication 16,
**caractérisé en ce qu'**il comprend l'étape consistant à :
- surveiller de façon continue la deuxième différence variable (Δf_{c}).

18. Procédé selon la revendication 16,
**caractérisé en ce qu'**il comprend l'étape consistant à :
- établir instantanément la deuxième différence de fréquence variable (Δf_{c}) à des intervalles de temps discrets.

19. Procédé selon la revendication 16 ou 17,
**caractérisé en ce qu'**il comprend l'étape consistant à :
- réduire la vitesse de balayage de façon continue ou pas à pas.

20. Procédé selon l'une quelconque des revendications 16 à 19
**caractérisé en ce qu'**il comprend les étapes consistant à :
- appliquer au détecteur de phase un signal de référence avec la fréquence sélectionnée,
- trouver la première tension de commande dans un moyen de stockage,
- convertir dans un convertisseur N/A le signal de sortie du moyen de stockage,
- appliquer la première tension de commande au VCO,
- détecter la deuxième différence de fréquence variable (Δf_{c}) provenant du détecteur de phase à échantillonnage,
- utiliser le signal de différence de fréquence pour commander un générateur de balayage,
- lorsque le signal de sortie du détecteur de phase à échantillonnage est une tension continue, ou lorsque l'intervalle de temps qui s'écoule entre deux impulsions consécutives provenant d'un comparateur, détectant des impulsions provenant du détecteur de phase, est suffisamment long, ce qui indique l'asservissement de phase sur l'harmonique de fréquence sélectionné, le balayage est désactivé.

21. Procédé selon la revendication 20,
**caractérisé en ce qu'**il comprend l'étape consistant à :
- appliquer un signal de commande provenant d'un moyen de commande supplémentaire au générateur de balayage, au filtre de boucle de la boucle d'asservissement de phase et au moyen de stockage pour garantir que l'harmonique de fréquence sélectionné sera trouvé en dépit du fait qu'il n'est pas possible de détecter un signal de sortie quelconque du détecteur de phase.

22. Procédé selon l'une quelconque des revendications 16 à 21,
**caractérisé en ce que**
l'activation / désactivation de la fonctionnalité d'intégration du filtre de boucle est commandée par un moyen de commande supplémentaire.
